# EUROPEAN PATENT APPLICATION

(11) **EP 0 607 656 A1**
(43) Date of publication of application: **27.07.1994**
(21) Application number: 93308533.4
(22) Date of filing: 26.10.1993
(51) Int. Cl.: H01L 25/065, H01L 23/48, H01L 23/52, H01L 23/498

(54) **Device having thin film overlay for interconnecting bond pads of a semiconductor device to a lead frame or flex circuit and method of making same**

(30) Priority: 26.10.1992 US 967474
(71) Applicant: TEXAS INSTRUMENTS INCORPORATED, Dallas Texas 75265 (US)
(72) Inventor: Wachtler, kurt P., Richardson, TX 75081 (US); Walter, David N., Richardson, TX 75082 (US); Mowatt, Larry J., Allen, TX 75002 (US)
(74) Representative: Nettleton, John Victor

(57) **Abstract**

A high density interconnect land grid array package device combines various electronic packaging techniques in a unique way to create a very thin, electrically and thermally high performance package for single or multiple semiconductor devices. A thin and mechanically stable substrate or packaging material (12) is selected that also has high thermal conductivity. Cavities (14) in the substrate or packaging material (12) accommodate one or more semiconductor devices that are attached directly to the substrate or packaging material. A lead frame or flex circuit (20) is positioned on a surface of said substrate or packaging material, adjacent the semiconductor device. A thin film overlay (18) having multiple layers interconnects the one or more semiconductor devices to leads on a lead frame or flex circuit.

## Description

### FIELD OF THE INVENTION

The present invention relates to the field of integrated circuit devices. More specifically, the present invention relates to a device having a thin film overlay that electrically connects bond pads of a semiconductor device to a lead frame or flex circuit.

### BRIEF DESCRIPTION OF THE DRAWINGS

The novel features believed characteristic of the invention are set forth in the appended claims. The invention itself, however, as well as other features and advantages thereof, will be best understood by reference to the detailed description, read in conjunction with the accompanying drawings, wherein:
Figure 1 is a top view of a semiconductor device wire bonded to a lead frame.
Figure 2 is an elevational view of a packaged semiconductor device having lead pins.
Figure 3 is a side view of a semiconductor device attached and wire bonded to a surface of a printed wiring board.
Figure 4 is a side view of a semiconductor device attached to the surface of a printed wiring board. A tape Automated Bonded (TAB) package electrically connects the semiconductor device to the printed wiring board.
Figure 5 is a side view of a semiconductor device mechanically and electrically attached to a printed wiring board via a flip TAB package.
Figure 6 is a side view of a device having a thin film overlay for interconnecting bond pads of a semiconductor device to a lead frame or flex circuit, according to one embodiment of the invention.
Figures 7-15 are successive process steps for a method of making a device according to one embodiment of the invention.
Figures 16-21 are additional process steps for a method of making a device according to another embodiment of the invention.
Figure 22 is a side view of a completed device constructed according to an embodiment of the invention.
Figure 23 is a side view of a device according to another embodiment of the invention.
Figure 24 is a side view of a device according to yet another embodiment of the invention.
Figure 25 is a side view of a device according to still yet another embodiment of the invention.
Figure 26 is a top view of a device according to yet still another embodiment of the invention.
Figure 27 is a top view of a device according to still another embodiment of the invention.
Figure 28 is a side view of multiple devices attached to a printed wiring board, according to yet still another embodiment of the invention.
Figure 29 is a partial side view of two devices each having a flex circuit arm folded down to minimize the spacing between the two devices, according to another embodiment of the invention.
Figure 30 is a top view of multiple devices attached to a panel or printed wiring board, according to still yet another embodiment of the invention.
Figure 31 is a side view of a device according to still yet another embodiment.
Figure 32 is a side view of the device of Figure 31 after the substrate or packaging material is removed.
Figure 33 is a side view of the device of Figure 32 attached to a printed wiring board.
Figure 34 is a side view of multiples of the device of Figure 32, attached to each other and to a printed wiring board.
Figure 35 is a side view of a device according to yet another embodiment of the invention.
Figure 36 is a top view of multiple devices according to an embodiment of the invention.
Figure 37 is a top view of multiple devices according to still yet another embodiment of the invention.
Figure 38 is a side view of a device of Figure 37.

### BACKGROUND OF THE INVENTION

The electronics industry is constantly demanding improved packaging for semiconductor devices. The demand is for packaging of reduced size and packaging that optimizes the operational speed of semiconductor devices.

One requirement of desired packaging is that it must manage thermal requirements that are driven by the heat generated by the semiconductor devices. Another requirement of desired packaging is adaptability to the constant reduction in the size of the final electronic system of which the packages are a part. As a result, packages must optimize heat dissipation while displacing minimal volume when assembled into an electronic system. An additional requirement is that packaging design and material selection should support the reduction of assembly process defects and not require new assembly capital and tooling.

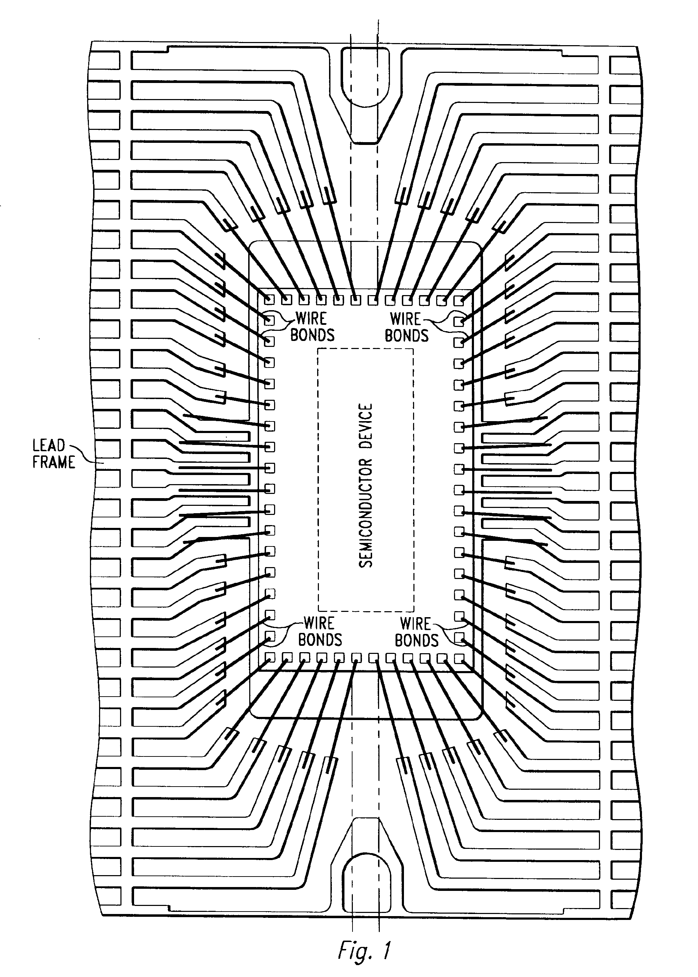

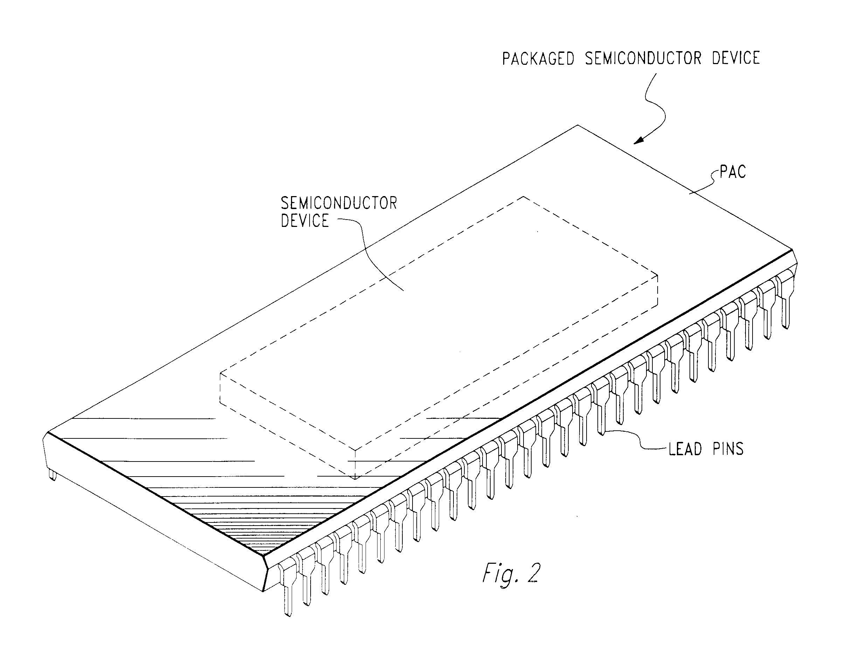

Figure 1 shows a conventional method of wire bonding a semiconductor device to a lead frame prior to packaging. Figure 2 shows the device of Figure 1 after packaging is complete. But problems are beginning to arise with conventional packaging as the industry requires: smaller and thinner packages; silicon devices with thinner background; smaller and closer together bond pads and lead frame circuits; and flat- terwire bonds and thinner plastic mold. The problems include lead frame handling defects, thermal management by thinner materials defects and assembly handling defects.

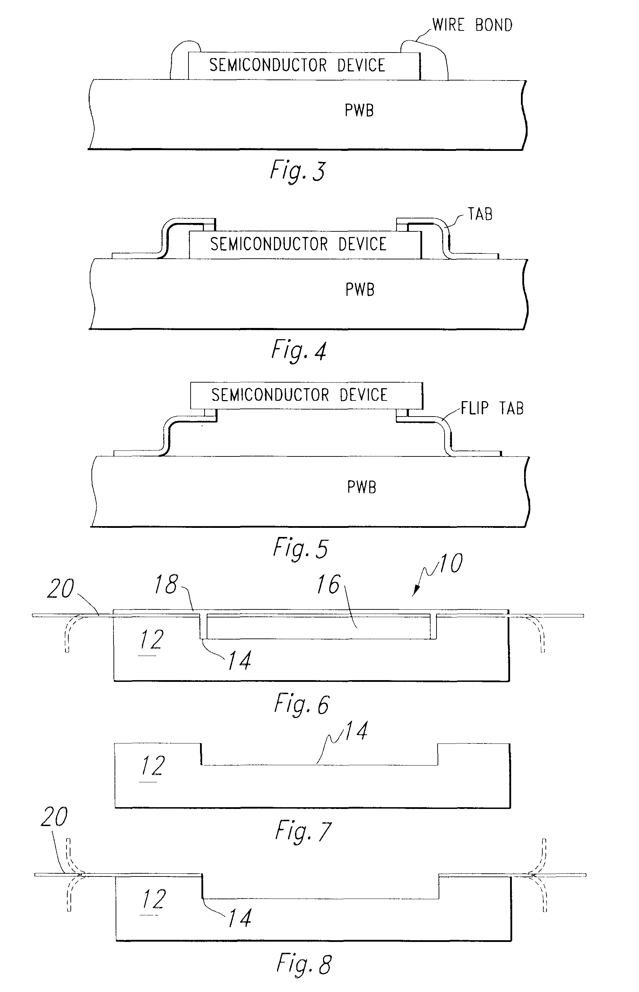

One method of reducing the physical area required by packaged devices is shown in Figure 3. An unpackaged semiconductor device is attached, and wire bonded, directly to the printed wiring board (PWB). A protective overcoat of glue or epoxy (not shown) is then formed over the semiconductor device, wire bonds and the corresponding portion of the surface of the printed wiring board. The advantage of this method is the reduction in physical area required by the unpackaged semiconductor device, as compared with a packaged device. One disadvantage is that the wire bonds are long and unsupported and susceptible to bending, breaking or shorting throughout the fabrication process. Another disadvantage is that the majority of the heat generated by the integrated circuit during normal operation must be dissipated through the printed wiring board. Since most glues or epoxies are poor conductors, heat transfer is inhibited if the printed wiring board design does not have special thermal management features.

A second disadvantage is that this technique is only applicable to semiconductor devices with relatively few bond pads, due to device and assembly yield and the limited PWB design feature sizes. Another disadvantage, for systems for multiple devices, is the need for the devices to be tested prior to assembly so that the final system has an acceptable yield.

Another method of reducing the physical area required by packaged devices is shown in Figure 4. A tape automated bonded (TAB) packaged semiconductor device is attached directly to the printed wiring board (PWB). A TAB package is used in place of wire bonds to electrically connect the semiconductor die to the printed wiring board. A protective overcoat of a polymer or plastic lid (not shown) is then formed over the semiconductor device, TAB package and the corresponding portion of the surface of the printed wiring board. As with the device of Figure 3, an advantage of this method is the reduction in physical volume required by the unpackaged semiconductor device, as compared with a conventional lead frame packaged device. Advantages of using TAB over wire bonds include superior electrical performance, more physical stability and less lead breaking or shorting. One disadvantage is that the TAB leads are long and remain susceptible to bending, breaking and occasional shorting throughout the fabrication process. Another disadvantage, as previously discussed, is that the majority of the heat generated by the integrated circuit during normal operation must be dissipated through the printed wiring board.

Still another method of reducing the physical area required by packaged devices is shown in Figure 5. This method is similar to that described above and pictured in Figure 4, except that the semiconductor device is face down verses face up. By the device being face down, the TAB leads are shorter and typically do not fan out from the center of the device to a large radius. This shortened package lead length will allow improved electrical signal characteristics. This reduced lead length requires the center to center spacing of each lead to adjacent lead to be small. Thus, the assembly of this package is significantly complicated. Non-conventional flip TAB assembly equipment requires further development if cost effective assembly is to occur. Heat transfer may be achieved via a heat sink (not shown) assembled to the TAB package and enhanced with thermal grease. The thermal grease is applied at the interface between the TAB package and the heat sink.

The physical volume required for a packaged semiconductor device also includes the "footprint" (area) required to accommodate the pins of a packaged device and the total height of the assembled package. A packaged device having a larger number of pins typically requires a larger footprint. Recent trends suggest that functions once accomplished through many devices are being consolidated into fewer and fewer devices, resulting in more complex semiconductor devices having more pins and corresponding larger footprints. These complex semiconductor devices can be connected to the printed wiring board (PWB) as shown in Figures 3-5, but such connection schemes do not fully address the combined problems of heat dissipation, achieving the desired reduction of system volume or acceptable system assembly cost.

Thus, there remains a need for a packaging technique that provides a very thin, electrically and thermally high performance package for single or multiple semiconductor devices.

### SUMMARY OF THE INVENTION

The present invention disclosed herein comprises a device having a thin film overlay for interconnecting bond pads of a semiconductor device to a lead frame or flex circuit, that combines various electronic packaging techniques in a unique way to create a very thin, electrically and thermally high performance package for single or multiple semiconductor devices.

In one embodiment of the invention, a thin and mechanically stable substrate or packaging material is selected that also has high thermal conductivity. Cavities in the substrate or packaging material accommodate one or more semiconductor devices that are attached directly to the substrate or packaging material. Athin film overlay having multiple layers interconnects each semiconductor device to a lead frame or a flex circuit. If two or more semiconductor devices are placed in cavities in the substrate or packaging material, the thin film overlay can also be used to interconnect the two or more semiconductor devices to each other. Lead pins of the lead frame or flex circuit arms provide electrical and mechanical attachment means to other system hardware.

A device according to the invention is thinner and electrically faster, with higher heat dissipation characteristics than traditional packaged devices. The device is thinner than conventionally packaged devices because one or more semiconductor devices are placed in cavities in a substrate or packaging material that is thin, mechanically stable and having high thermal conductivity. The device is faster because the distance of the electrical path between the semiconductor device or devices and the lead frame orflex circuit is shorter and has improved electrical shielding as compared to the distances of the electrical paths of conventional wire bonded devices. The device has higher heat dissipation characteristics than existing devices because the substrate or packaging material is thin and it has high thermal conductivity. Thus, the distance that heat must travel from a semiconductor device to the environment is small. In addition, a heat sink may be added to the substrate or packaging material to increase heat dissipation.

Interconnecting a lead frame orflex circuit to one or more semiconductor device with a thin film overlay, according to the invention, is adaptable to a wide range of electronic packaging applications. The elimination of wire bonds or TAB attachment solder joints should result in higher packaged device reliability and potentially lower cost because of reduction in manufacturing and assembly process steps.

### DETAILED DESCRIPTION OF THE INVENTION

Figure 6 discloses a device having a thin film overlay for interconnecting bond pads of a semiconductor device to a lead frame or flex circuit, shown generally at 10. The device combines various electronic packaging techniques in a unique way to create a thin, electrically and thermally high performance package for single or multiple semiconductor devices. The size and shape of the device is merely descriptive for the purposes of this application. In practice, devices according to the invention will exist in various sizes and shapes.

Device 10 includes a substrate or packaging material 12 having a cavity 14 that accommodates semiconductor device 16. The surface of semiconductor device 16 having pads for electrical connection (not shown), faces away from cavity 14. The pads of semiconductor device 16 are connected through a thin film overlay 18 to a lead frame or flex circuit 20 sandwiched between thin film overlay 18 and substrate or packaging material 12.

The electrical path through device 10 begins with a signal coming off a printed wiring board (PWB) or other external circuitry (not shown), after which the signal travels through a lead of lead frame or flex circuit 20, through signal pathways in thin film overlay 18 and into semiconductor device 16. A signal returning to the printed wiring board (PWB) or other external circuitry propagates through this sequence in reverse order. The thin film overlay 18 may be designed to accommodate special electrical requirements, for example high speed transmission lines, by adding electrical protective signals and/or layers in the thin film overlay. The primary thermal path for semiconductor device 16 to the air is also very short because semi- conductor device 16 is attached directly to the substrate or packaging material 12. This thermal path may be enhanced with the addition of a heat sink (not shown) to the substrate or packaging material. The secondary path is through thin film overlay 18.

A method of a device according to one embodiment of the invention is shown in Figures 7-15. The method begins with the selection of a substrate or packaging material made of ceramic, aluminum nitride, molded plastic, compound molded plastic, flex circuit/molded plastic, PWB laminate, metal, artificial diamond, a combination of one or more of these materials or other similar types of material. The substrate or packaging material must be thin, mechanically stable and have high thermal conductivity. The substrate or packaging material may also be formed with heat slugs to facilitate heat dissipation.

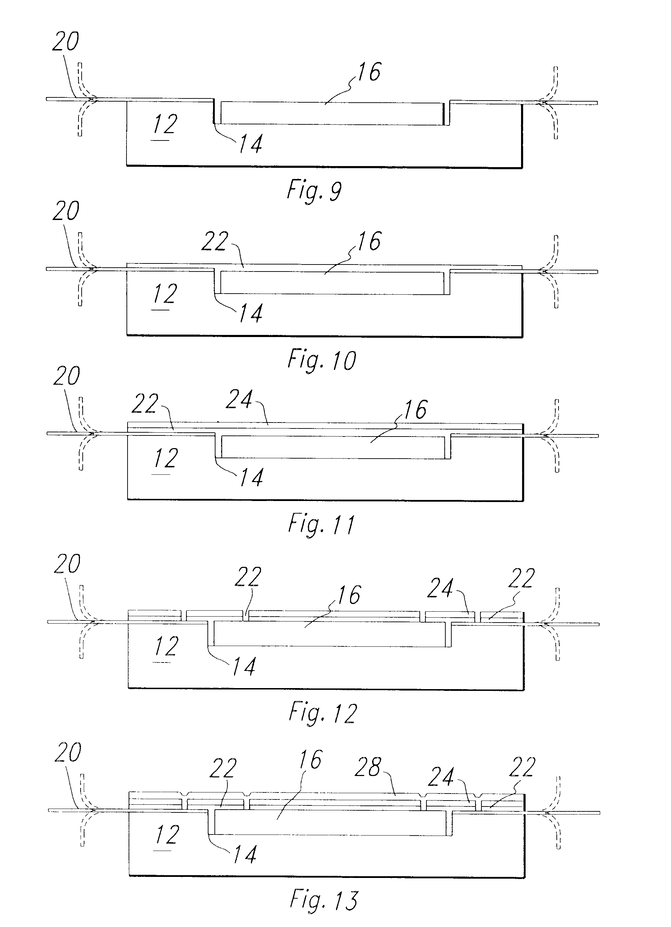

Once a substrate or packaging material 12 has been selected, a cavity 14 is formed or milled out in material 12, as shown in Figure 7, to match the dimensions of a semiconductor device. A lead frame of flex circuit 20 may be either molded into the substrate or packaging material 12 in a one step process or added subsequently in a separate operation, as shown in Figure 8. Next, a semiconductor device 16 is positioned manually or by machine (i.e. pick and place machine) within cavity 14, as shown in Figure 9. Semiconductor device 16 is secured within cavity 14 of substrate 12 by adhesive, press fit or other similar means. If adhesive material is used, the die attach material may have a high or low modulus of elasticity, be thermally conductive or non-conductive and electrically conductive or non-conductive depending on the die characteristics and system end use application. The adhesive material may or may not fill the gap between the edge of semiconductor device 16 and cavity 14. The surface of semiconductor device 16 opposite cavity 14 should contain the bond pads of the die.

Next, a layer of dielectric material 22 is formed or deposited over the entire substrate/die/lead frame or flex circuit subassembly, as shown in Figure 10. The dielectric material selection may include liquid resin and/orfiims or combinations of these materials. Polyetherimide (G.E. brandname ULTEM) is but one material that may be used as an effective dielectric for layer 22. The method of application may also vary from dispensing a liquid to placing down a sheet of cast film. The film may be a thermal plastic or thermal set material. An optional step at this point would be the formation of a polymer layer 24 over dielectric layer 22, as shown in Figure 11. Thus, if dielectric layer 22 is a layer of polyetherimide, an acceptable material for poly layer 24 would be polyimide material (DuPont brandname KAPTON) and laminated. Acom- bination of materials 22 and 24 (for example, material 24 coated on material 26 film) into one piece of material is an alternative to separate sheets of material.

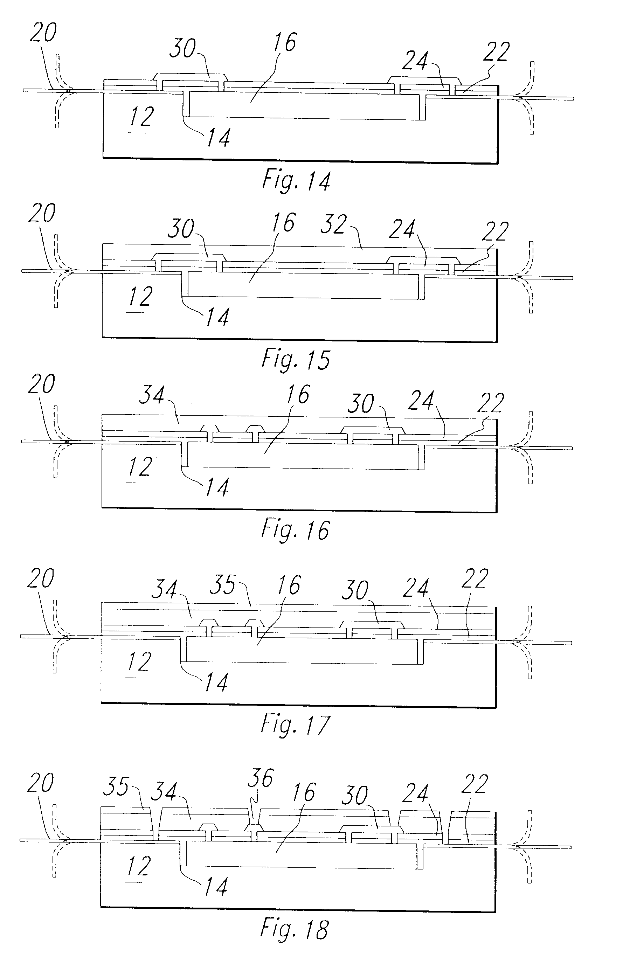

The next step requires the construction of vias 26 through any layer or layers above dielectric layer 22, (e.g. optional poly layer 24), through dielectric material 22 and down to the bond pads of semiconductor device 16, and down to selected leads of lead frame or flex circuit 20, as shown in Figure 12. This may be accomplished by ablation (i.e., laser drilling), chemically with a liquid, gas, plasma or other suitable means. Next, a metallization layer 28 is deposited or formed on top of dielectric layer 22 (on top of poly layer 24 if optional layer used) and into vias 26, as shown in Figure 13. If deposition is used, deposition may be performed with standard HDI dry deposition techniques or any other material deposition techniques. A typical metallization material may be sequential layers of metal such as titanium, copper and titanium. Imaging and photolithography processes are then performed on metallization layer 28, resulting in metallized tracks 30 (only two shown), as shown in Figure 14. The resulting pattern with its number and location of metallized tracks can be varied to adapt to different semiconductor device, lead frame or flex circuit and package orientation requirements. A solder mask or protective overcoat 32 is then formed on metallized tracks 30 and above the top dielectric layer, as shown in Figure 15.

In another embodiment of the invention, the steps of forming or depositing dielectric layer 22 through metallized tracks 30 are repeated, beginning with the forming or depositing of a dielectric layer 34 on top of patterned metallized layer 30, as shown in Figure 16. As stated previously, the dielectric material selection may include liquid resin and/orfilms or combinations of these materials. The method of application may also vary from dispensing a liquid to placing down a sheet of cast film. An optional step at this point would be the formation of a polymer layer 35 over dielectric layer 34, as shown in Figure 17. Thus, if dielectric layer 34 is a layer of partially cured resin, an acceptable material for layer 35 would be a fully cured polyimide material.

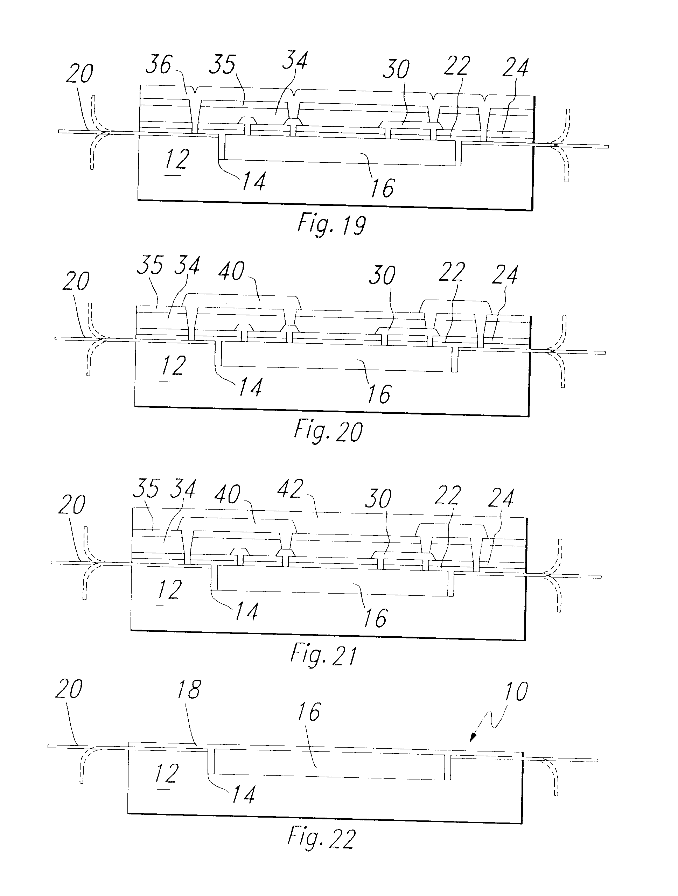

The next step requires the construction of vias 36 through any layer or layers above dielectric layer 34, (e.g. optional polymer layer 35), through dielectric layer 34 and down to metallized pads 30, and down to selected leads of lead frame or flex circuit 20, as shown in Figure 18. Next, a metallization layer 38 is deposited or formed on top of dielectric layer 34 (on top of poly layer 35 if optional layer used) and into vias 36, as shown in Figure 19. If deposition is used, deposition may be performed with standard dry deposition techniques or any other material deposition techniques. Imaging and photolithography processes are then performed on medullization layer 38, resulting in metallized tracks 40 (only two shown), as shown in Figure 20. The resulting pattern with its varied number and location of metallized tracks can be varied to adapt to different semiconductor device and package orientation requirements. Asolder mask or protective overcoat 42 is then formed on metallized tracks 40 and above the top dielectric layer, as shown in Figure 21. Completed thin film overlay 18 is not to scale in the figures. In practice, thin film overlay 18 will usually be much smaller in height as compared to semi- conductor device 16 and substrate or packaging material 12.

The steps beginning with forming or depositing a dielectric layer and ending with the patterning of a metallization layer may be repeated as necessary to build a thin film overlay 18 with the required number of layers. After the last metallization layer is patterned, a solder mask or overcoat layer is formed to protect the metallized tracks. Aside view of a completed high density interconnect (HDI) land grid array package is shown in Figure 22. Note that thin film overlay 18 is small in height as compared to substrate or packaging material 12.

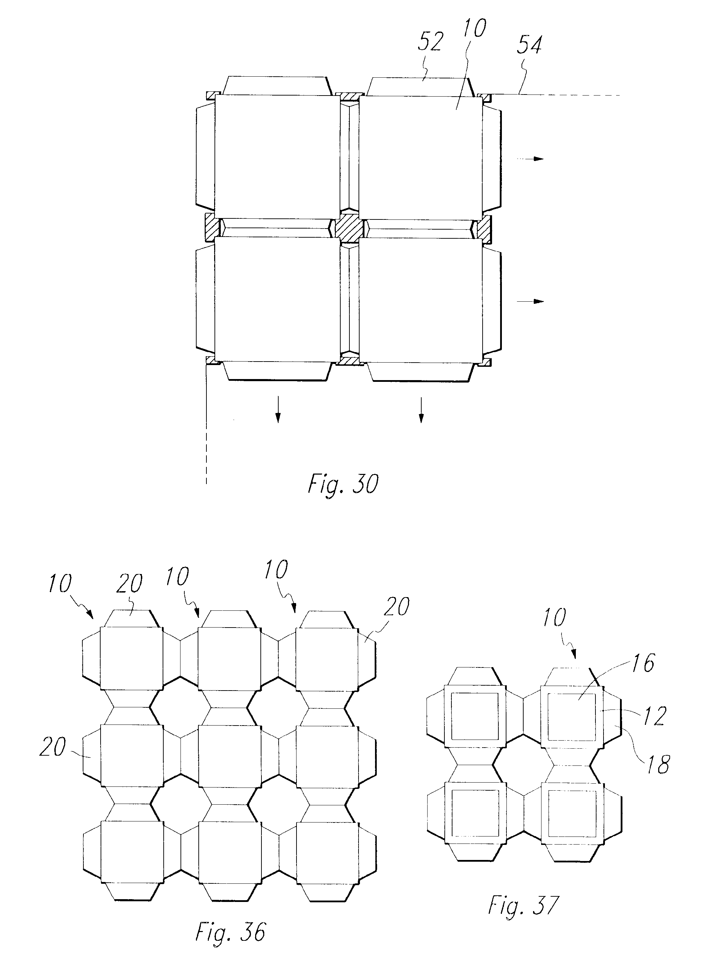

The flex circuit or lead frame previously defined for this package is required to allow the assembly of this package to the next level of electronic hardware, the PWB or equivalent. But, this extension of material utilizes valuable surface area of the material during the manufacturing operation, as shown in Figure 36. Note the distance between each package that is required to allow for the flex circuit or lead frame.

There are two alternatives to increasing the utilization of the material surface area. The first alternative is to eliminate the flex circuit or lead frame, as shown in Figure 37 and 38. This will be possible if the flexible arm can be of minimum length for the assembly to PWB process. This will allow the thin film overlay 18 to act as the flex circuit or lead frame. Then, the distance between packages during the manufacturing process may be reduced.

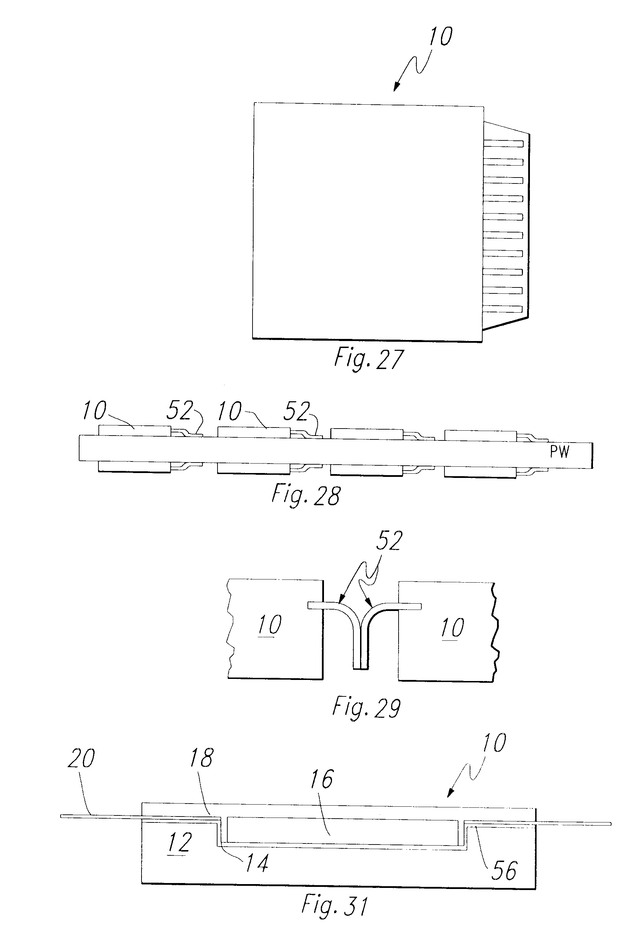

The second alternative, if the length of the flexible arm must exceed what is considered efficient spacing of the packages 10 during manufacturing, is to bend the flex circuit 52, as shown in Figure 29. This will allow the packages to be packed close together in a multiple package carrier 54 during manufacturing, as shown in Figure 30.

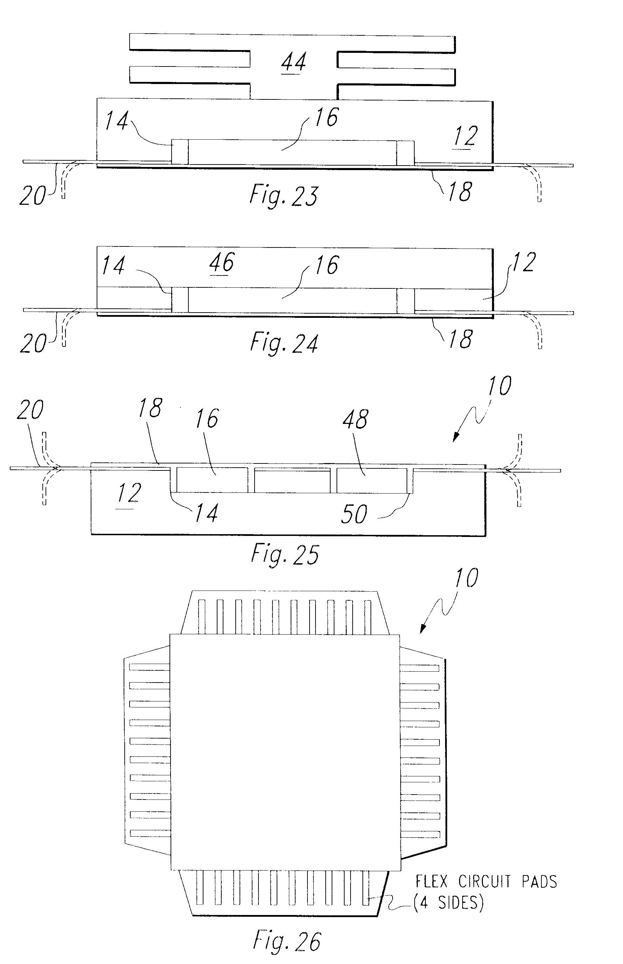

In another embodiment of the invention, the thermal path from semiconductor die 16 to the air is enhanced by the addition of a heat sink 44, as shown in Figure 23. Heat sink 44 is welded, soldered, glued, press fit or attached by any other suitable means onto the substrate or packaging material 12, depending upon the composition of substrate or packaging material 12 and heat sink 44. The size and shape of heat sink 44 may be changed as needed to meet specific design heat dissipation and physical space specifications. Heat sink 44 may also be used in combination with a substrate or packaging material that incorporates one or more heat slugs in the substrate or packaging material.

In yet another embodiment of the invention, shown in Figure 24, substrate or packaging material 12 is PWB laminate. Cavity 14 in substrate or packaging material 12 may be designed to expose a metal base 46 for the semiconductor device attach. The metal may be selected to customize the substrate thermal expansion rate and maximize the overall package heat dissipation characteristics. A heat sink (not shown) may also be attached to metal base 46 for increased heat dissipation.

In still another embodiment of the invention, shown in Figure 25, a second semiconductor device 48 is placed within substrate or packaging material 12 and connected to semiconductor lead frame or flex circuit 20 by thin film overlay 18. The additional steps required supplement the methods steps previously discussed for making a packaged device having a single semiconductor device. An additional step would require the formation or milling of a second cavity 50 in substrate 12. Semiconductor device 48 would be placed in cavity 50 and secured in the same manner as semiconductor device 16. If semiconductor devices 12 and 48 are not to be interconnected, the method for forming thin film overlay 18 and any additional steps are the same as previously discussed, only expanded to include and account for semiconductor device 48. But if semiconductor devices 12 and 48 are to be interconnected, an additional step would require that thin film overlay 18 be modified to include some metal layer interconnection between the two semi- conductor devices as well.

A packaged device according to the invention can also be expanded to include more than two semiconductor devices (not shown). The size of the substrate or packaging material can be enlarged as necessary to hold the desired number of semiconductor devices. Additional cavities will have to be formed or milled in an enlarged substrate or packaging material for the additional semiconductor devices. If the semiconductor devices are not to be interconnected, the method for forming the thin film overlay and any additional steps are the same as previously discussed, only expanded to include and account for the additional semiconductor devices. But if some or all of the semiconductor device are to be interconnected, at least one additional step will require that the thin film overlay be modified to include some metal layer interconnection between the semiconductor devices.

Figure 26 shows a top view of a packaged device having four sides of flex circuit pads, according to another embodiment of the invention. A packaged device having multiple sides of flex circuit pads can be designed to have I/O's on more than one side that can serve for test and/or burn-in, then be trimmed off, as shown in Figure 27. The circuit going to the I/O's for test/burn-in can be designed as a fuse so if a die fai Is, it blows the single fuse and does not affect the balance of the test set. Figure 28 shows multiple packaged devices having their flex circuit pads 52 attached by conductive adhesive or solder to a printed wiring board (PWB).

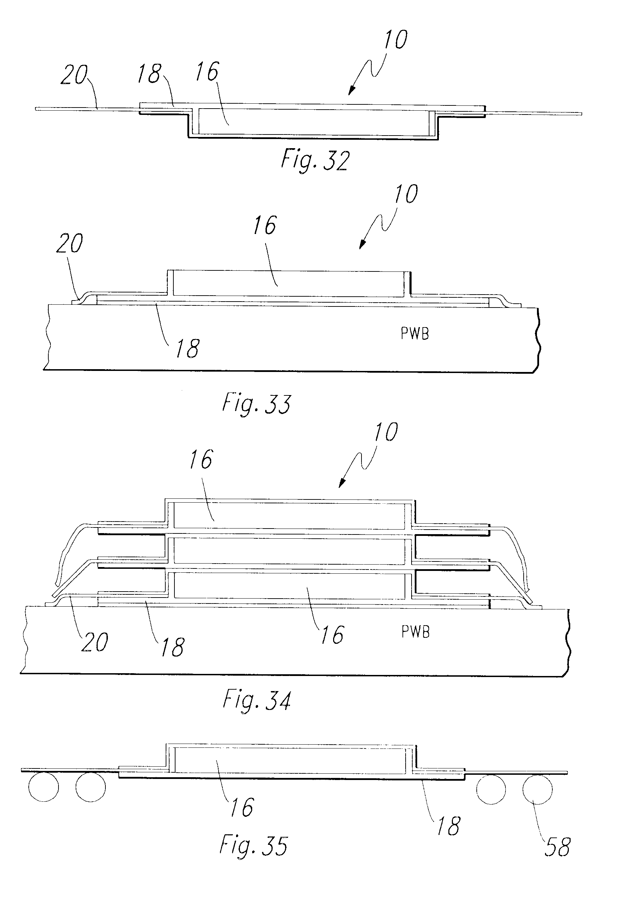

In yet another embodiment of the invention, a releasable material 56 is formed on the upper surface and cavity of the substrate or packaging material prior to the die and lead frame or flex circuit being attached. Figure 31 shows a packaged device having releasable material 56. Material 56 should release the substrate from the die and lead frame or flex circuit by a method such as melting, dissolving or separating due to a peeling force, to leave the device of Figure 32. The device of Figure 32 can then be directly attached to a PWB with a conductive adhesive or solder attachment to the lead pins or flex circuit arms, as shown in Figure 33. Packaged devices having double sided flex circuits can also be stacked onto a PWB as shown in Figure 34. The attachment means can be by conductive adhesive or solder attachment. The device of Figure 31 can also have solder balls 58 or bumps attached to the flex circuit as shown in Figure 35.

While this invention has been described with reference to illustrative embodiments, this description is not to be construed in a limiting sense. Various modifications to the illustrative embodiments, as well as other embodiments of the invention will be apparent to persons skilled in the art upon reference to this description. It is therefore contemplated that the appended claimswill cover any such modifications or embodiments as fall within the true scope of the invention.

## Claims

1. A device, comprising:
a package;
a semiconductor device within said package;
a lead frame or flex circuit on a surface of said package and adjacent at least one side of said semiconductor device; and
a thin film overlay electrically connecting bond pads on said semiconductor device to leads on said lead frame or flex circuit.

2. The device of Claim 1, in which said package includes a cavity having dimensions the same or greater than the semiconductor device.

3. The device of Claim 2, wherein said package includes at least one heat slug.

4. The device of Claim 2, including a device attach adhesive in the cavity.

5. The device of Claim 1, wherein said thin film overlay includes at least one layer of dielectric material and at least one layer of conductive material.

6. The device of Claim 5, wherein a layer of thin film overly adjacent said semiconductor device is a layer of dielectric material.

7. The device of Claim 6, wherein said layer of conductive material is patterned into a first layer of respective conductors.

8. The device of Claim 7, including vias filled with electrically conductive material from bond pads of said semiconductor device through said layer of dielectric material and to respective conductors, and additional vias filled with electrically conductive material from said respective conductors to leads of said lead frame or flex circuit.

9. The device of Claim 8, including a second layer of dielectric material adjacent said first layer of respective conductors and a second layer of conductive material patterned into a second layer of respective conductors.

10. The device of Claim 9, including a via filled with electrically conductive material from one conductor of said first layer of respective conductors, through said second layer of dielectric material, and to a conductor of a second layer of respective conductors.

11. The device of Claim 10, including vias filled with electrically conductive material from conductors of said second layer of respective conductors to respective leads of said lead frame or flex circuit.

12. The device of Claim 10, including vias filled with electrically conductive material from conductors of said first layer of respective conductors, through said second layer of said dielectric material, and to conductors of said second layer of respective conductors.

13. The device of Claim 9, including at least one additional alternating pair of layers of dielectric material and conductive material patterned into a layer of respective conductors, with each additional layer of dielectric layer being adjacent the previous layer of respective conductors.

14. The device of Claim 13, including vias filled with electrically conductive material from conductors of a previous layer of respective conductors, through an adjacent layer of dielectric material and to conductors of another layer of respective conductors.

15. The device of Claim 6, including at least a second dielectric layer between said dielectric layer and said layer of conductive material.

16. The device of Claim 13, including at least an additional dielectric layer between each dielectric layer and the next layer of conductive material.

17. The device of Claim 1, including at least one additional semiconductor device within said package.

18. The device of Claim 17, wherein said thin film overlay connects some of the bond pads of said semiconductor devices to each other and other of the bond pads to electrically conductive pads on a layer of said thin film overlay.

19. A device, comprising:
a semiconductor device;
a lead frame or flex circuit; and
a thin film overlay electrically connecting bond pads on said semiconductor device to leads on said lead frame or flex circuit.

20. A method, comprising:
placing a semiconductor device in a package;
placing a lead frame or flex circuit on a surface of said package and adjacent at least one side of said semiconductor device; and
forming a thin film overlay on a surface of said semiconductor device for electrically connecting bond pads on said semiconductor device to leads on said lead frame or flex circuit.

21. The method of Claim 20, including, placing at least one additional semiconductor device in said package.

22. The method of Claim 21, wherein said forming said thin film overlay includes connecting bond pads on said at least one additional semiconductor device to electrically conductive pads on said layer of said thin film overlay.

23. The method of Claim 21, wherein said forming said thin film overlay includes connecting some of the bond pads of said semiconductor devices to each other and other of the bond pads to electrically conductive pads on a layer of said thin film.

24. The method of Claim 21, wherein said semiconductor device is placed in a cavity, within the package, that matches the dimensions of the semiconductor device.

25. The method of Claim 24, including depositing a layer of device attach adhesive into said cavity before said semiconductor device is placed in said cavity.

26. A device comprising:
a semi-conductor device,
a plurality of leads, and
a thin film overlay electrically connecting bond pads on said semi-conductor device to said leads.
